# EUROPÄISCHE PATENTSCHRIFT

(11) **EP 2 345 090 B1**
(45) Veröffentlichungstag und Bekanntmachung des Hinweises auf die Patenterteilung: **17.07.2013**
(21) Anmeldenummer: 09783976.5
(22) Anmeldetag: 13.10.2009
(51) Int. Cl.: H01L 31/068, H01L 31/18, H01L 31/0224, H01L 31/0216, H01L 31/0236

(54) **SOLARZELLE UND VERFAHREN ZU DEREN HERSTELLUNG**
SOLAR CELL AND METHOD FOR PRODUCING THE SAME
CELLULE SOLAIRE ET PROCÉDÉ DE FABRICATION

(30) Priorität: 31.10.2008 DE 102008054167; 30.06.2009 DE 102009031151
(43) Veröffentlichungstag der Anmeldung: 20.07.2011
(73) Patentinhaber: Robert Bosch GmbH, 70469 Stuttgart (DE)
(72) Erfinder: KROKOSZINSKI, Hans-Joachim, 69226 Nußloch (DE)
(86) Internationale Anmeldenummer: PCT/EP2009/063341
(87) Internationale Veröffentlichungsnummer: WO 2010/049268

(56) Entgegenhaltungen:
- EP-A1- 1 732 142
- WO-A1-00/55923
- US-A1- 2004 261 840

## Beschreibung

Die Erfindung betrifft eine Solarzelle mit einem n-dotierten Halbleitersubstrat, insbesondere aus Silizium, mit vorderseitigen Basisbereichen und einer auf der Vorderseite aufgebrachten fingerartigen Basis-Kontaktstruktur sowie Basis-Kontaktbahnen auf der Rückseite und die fingerartige Kontaktstruktur mit den Kontaktbahnen verbindenden Durchgangskontaktierungen (Vias) sowie ein Verfahren zu deren Herstellung.

Solarzellen mit Kontaktfingern auf der Vorderseite, die mit lötfähigen Kontaktbahnen (Busbars) auf der Rückseite durch lasergebohrte, metallgefüllte Löcher verbunden sind, sind schon lange bekannt (Patent Abstracts of Japan, Publication No. 58-039071 (1983); Patent Abstracts of Japan, Publication No. 04223378 (1992)]. Sie werden unter der Bezeichnung Metal Wrap Through(MWT)-Zellen auf p-dotiertem, meist multikristallinen Basismaterial mit einem durch Phosphordiffusion erzeugten vorderseitigen Emitter hergestellt (F. Clement et al, 23rd EUPVSEC, Valencia (2008), paper 2DV.1.10). Dabei wird die Rückseite wie in Standardsolarzellen zwischen den Rückseiten-Emitterbusbars und den Basiskontaktlötpunkten mit Aluminiumpaste großflächig abgedeckt, um ein sogenanntes Back Surface Field (BSF) zu bilden und die Rückseite zu verspiegeln.

Beispielsweise wird in EP 0985233 B1 oder WO 98/54763 eine MWT-Zelle sowohl auf n- als auch p-dotierten Wafern als Ausgangsmaterial beschrieben, die einen homogenen Emitter auf der Vorderseite, in den Durchkontaktierungen und in Bereichen der Rückseite um die Durchkontaktierungen herum aufweist. Dabei werden die Gebiete, in denen später auf der Rückseite die Basiskontakte liegen sollen, während der POCl₃-Diffusion des Emitters durch eine Maskierschicht abgedeckt, die hinterher entfernt wird, bevor die Rückseitenmetallisierung aufgebracht wird.

Ebenfalls vor vielen Jahren wurde neben der Passivierung des Emitters auch das passivierte Rückseiten-BSF mit lokalen Kontakten für sog. PERC-Zellen (Passivated Emitter and Rear (local) Contacts) vorgeschlagen (A.W. Blakers et al., Appl. Phys. Lett., 55 (1989), p.1363-1365; G. Agostinelli et al., 20th European Photovoltaic Solar Energy Conference (2005), Barcelona, p. 647, P. Choulat et al, 22nd European Photovoltaic Solar Energy Conference (2007), Milano).

Ferner ist aus WO 00/55923 eine Solarzelle mit Front- oder Rückseitenkontaktierung sowie ein Verfahren zur Herstellung einer solchen Solarzelle bekannt. Eine gleichzeitige Front- und Rückseitenkontaktierung an einer Solarzelle ist nicht vorgesehen.

Weitere Solarzellen mit Rückseitenkontaktierungen sind in US 2004/0261840 A1 sowie in EP 1732142 A1 beschrieben.

Als Nachteile bekannter MWT-Zellen haben sich die Folgenden herausgestellt:

Standardmäßige MWT-Zellen haben den Emitter auf der Vorderseite und müssen für eine Verbindung zu den Emitter-Busbars auf der Rückseite in den meist lasergebohrten Löchern eine geschlossene Emitterdotierung an den Lochwänden besitzen, damit kein Shunting zum Basismaterial auftritt. Somit müssen die Löcher durch eine Diffusion aus der Gasphase, wie POCl₃ (bei p-Material) oder BBr₃ (bei n-Material), perfekt ausgekleidet werden.

Zusätzlich ergibt sich daraus die Schwierigkeit, die Emitterdotierung auch in einem Streifen im Bereich der vorgesehenen rückseitigen Emitterbusbars gegenüber der benachbarten Rückseitendotierung (BSF) zu isolieren. Bisher wird das Rückseiten-BSF, wie oben erwähnt, durch Al-Siebdruck und Sintern, also durch Überkompensation der vorher in beide Oberflächen eingebrachten Phosphor-Dotierung, hergestellt. Beim Druck werden die RS-Emitterstreifen zwar frei gelassen, aber die Isolierung zwischen den p⁺- und n⁺-Bereichen muss dann nachträglich, z.B. mit einem Lasergraben um die Emitterbusbars herum, hergestellt werden.

Aufgabe der Erfindung ist es, eine verbesserte Solarzelle, die vollständig von der Rückseite her kontaktiert ist und zuverlässig und mit hoher Ausbeute herstellbar ist und flexible Optionen hinsichtlich einer spezifischen Kontaktierung und Passivierung bietet, sowie ein entsprechendes Herstellungsverfahren anzugeben.

Diese Aufgabe wird in ihrem Vorrichtungsaspekt durch eine Solarzelle mit den Merkmalen des Anspruchs 1 und in ihrem Verfahrensaspekt durch ein Verfahren mit den Merkmalen des Anspruchs 10 gelöst. Zweckmäßige Fortbildungen des Erfindungsgedankens sind Gegenstand der jeweiligen abhängigen Ansprüche.

Es werden eine neuartige Solarzellenstruktur und eine (beispielhafte) Prozessschrittfolge für die Herstellung einer entsprechenden Solarzelle vorgestellt, die einen vollflächigen Aluminiumemitter auf der Rückseite von n-Silizium und frontseitige FSF-Kontaktfinger enthält, die durch Laserbohrungen mit Lötkontaktbahnen oder Lötkontaktbahnstücken auf der Rückseite verbunden sind, die in Aussparungen im ansonsten vollflächigen Emitter und in der ansonsten vollflächigen Aluminiummetallisierung oder der ansonsten vollflächigen dielektrischen Passivierschicht mit lokalen Durchkontaktierungen der ansonsten vollflächigen Aluminiummetallisierung liegen.

Das vorgeschlagene neuartige MWT-Zellkonzept sieht in zweckmäßigen Ausgestaltungen vor, dass
a) das Ausgangsmaterial ein (vorzugsweise, aber nicht zwingend) monokristalliner n-Silizium-Wafer mit beliebiger Form ist;
b) im Gegensatz zu allen Konzepten nach dem Stand der Technik der Emitter auf der Rückseite eines n-Typ-Wafers liegt, d.h. dass die Vorderseite und die Lochinnenwände keinen pn-Übergang, sondern einen n⁺n-Übergang aufweisen;
c) die p⁺-Emitterdotierung durch Al-Diffusion aus einer durch Aufdampfen oder Sputtern hergestellten dünnen Quellschicht oder Quellschichtfolge erfolgt,
d) eine Al-basierte Dünnschichtmetallisierung des Emitters auf der Rückseite wahlweise direkt und großflächig oder mittels Passivierung mit lokaler Kontaktierung des Emitters aufgebracht wird (PERC);
e) lötfähige (Ag-)Kontaktflächen auf der Al-basierten Dünnschichtmetallisierung des (passivierten oder nicht passivierten) Emitters und in den im Emitter frei gelassenen Bereichen des BSF aufgebracht werden können;
f) die Isolation zwischen dem Rückseitenemitter und den aus den Vias auf die Rückseite durchtretenden BSF-Dotierbereichen bereits während des Produktionsprozesses hergestellt wird, so dass keine nachträgliche Lasergraben-Isolation mehr durchgeführt werden muss.

Die vorgeschlagene MWT-Solarzellenstruktur in ihren bevorzugten Ausführungen, insbesondere mit einem Aluminium-diffundierten p⁺-Emitter auf der Rückseite eines n-dotierten Wafers, der auf der Vorderseite auf einer Phosphor-basierten n⁺-Dotierung mit Siliziumnitrid-Passivierung bzw. Antireflexschicht (ARC) ein standardmäßiges Silberfinger-H-Grid besitzt, das wiederum über lasergebohrte, silberpastengefüllte Löcher (Vias) mit Busbars, die auch aus vielen linear hinter einander liegenden Busbarflecken bestehen können, auf der Rückseite verbunden ist, besitzt folgende Vorteile:
1) n-Basis-dotierte Wafer besitzen eine höhere Lebensdauer der Minoritätsladungsträger (hier: Löcher) und ermöglichen damit den Aufbau einer MWT-Zelle mit Rückseitenemitter bereits bei den heute üblichen Waferdicken von 180µm+/- 20µm.
2) Da die Wände der Vias wie die Vorderseite nur einen n⁺n-high-low-Übergang besitzen, besteht (anders als bei der standardmäßigen MWT-Zelle auf p-Wafern mit vorderseitigem n⁺-Emitter und n⁺-Emitterdotierung in den Vias) keine Gefahr des Shunting und der j₀₂-Erhöhung in den Vias; denn wenn die Lochmetallisierung durch die hochdotierte n⁺-Schicht hindurch kontaktieren sollte, bleibt der Kontakt doch im Basispolaritätsbereich (n).
3) Dadurch, dass die rückseitigen Basiskontaktflächenbereiche, die Löcher und die Vorderseite n⁺-dotiert sind und die Silberpasten gefahrlos durch das ARC und auf der Rückseite sogar ohne ARC durch die n⁺-Schicht (s. Punkt 2) hindurch kontaktieren dürfen, dürfen Pasten 1 und 2 die gleiche sein.
4) Dadurch, dass die Rückseitenpassivierschicht erst nach dem Feuern der vorderseitigen Silberfinger, der rückseitigen Basiskontaktflächen und der Lochmetallisierung abgeschieden wird, muss diese keine Hochtemperaturbehandlungen bei T>800°C aushalten; die höchste Temperatur, die diese Schicht hinterher noch erleben muss, ist die niedrige Sintertemperatur der Rückseiten-Ermitterkontaktflächen-Paste 3 (<560°C); somit bestehen bessere Chancen für eine erfolgreiche Rückseitenpassivierung.
5) Dadurch, dass die Aluminium-Emitterdotierung derart strukturiert ausgeführt wird, dass die rückseitigen FSF-Busbarbereiche in schmaleren Streifen bzw. Flecken erzeugt werden können als die, die vorher im Emitter freigelassen worden sind, muss zum Schluss des Zellenherstellprozesses keine Lasergrabenbasierte Isolation der p⁺- und n⁺-Gebiete erfolgen.

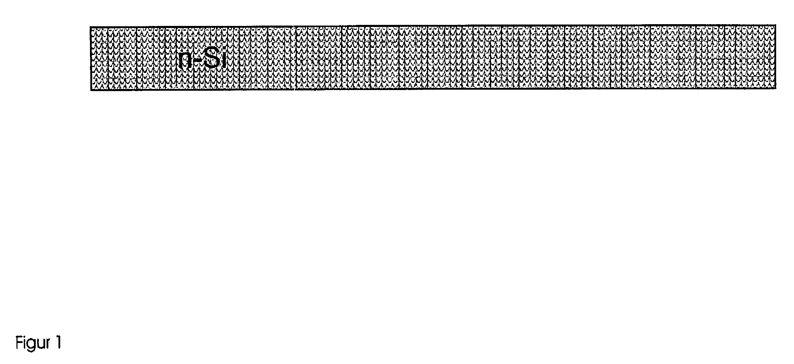

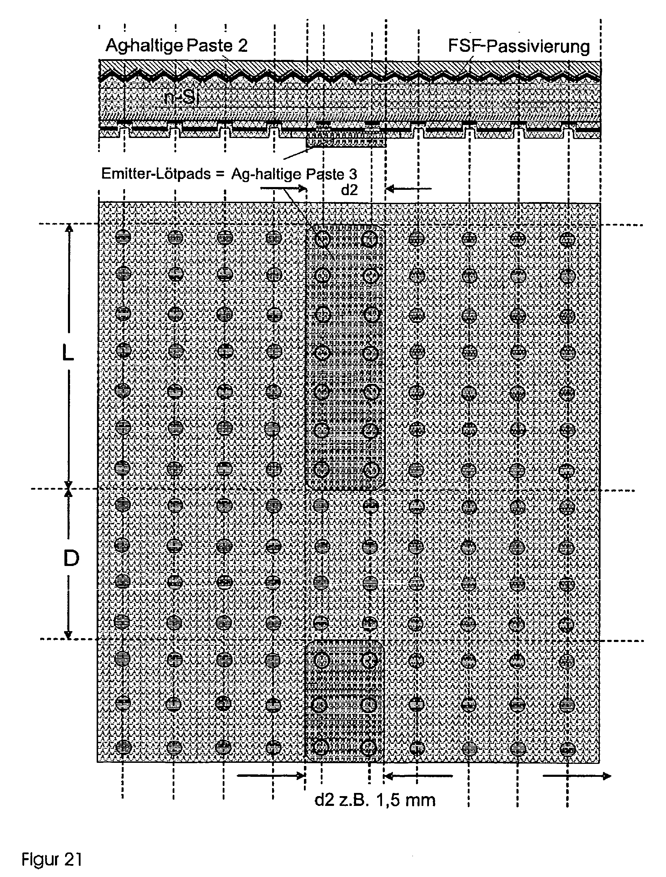

Vorteile und Zweckmäßigkeiten der Erfindung ergeben sich im Übrigen aus der nachfolgenden Beschreibung eins Ausführungsbeispiels anhand der Figuren. Die Figuren 1 bis 22 zeigen schematische Ausschnittsdarstellungen einer Ausführungsform der erfindungsgemäßen Solarzelle 1 bzw. des Herstellungsverfahrens in Querschnitten bzw. Untersichten (Draufsichten auf die zweite Hauptoberfläche 30). Die einzelnen Figuren sind aufgrund ihrer Beschichtung weitgehend selbsterklärend, so dass die nachfolgend gegebene Beschreibung lediglich skizzenhaft und als Ergänzung zu den Figuren zu verstehen ist.

Es wird hier insbesondere darauf verzichtet, die aus dem Stand der Technik bekannten Maßnahmen zur Erzeugung einer selektiven Dotierung unter den vorderseitigen Silberfingern in die Beschreibung aufzunehmen, ohne auszuschließen, dass sie in der erfindungsgemäßen Zelle angewandt werden könnten, um die Blaulichtempfindlichkeit der Vorderseite zu verbessern.

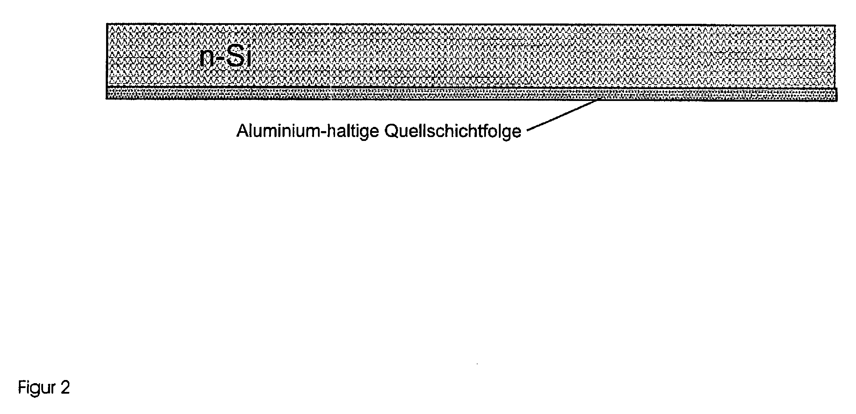

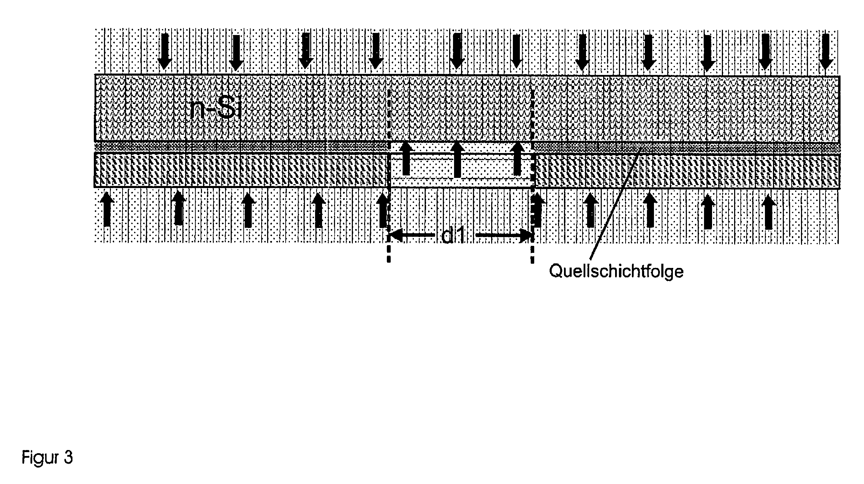

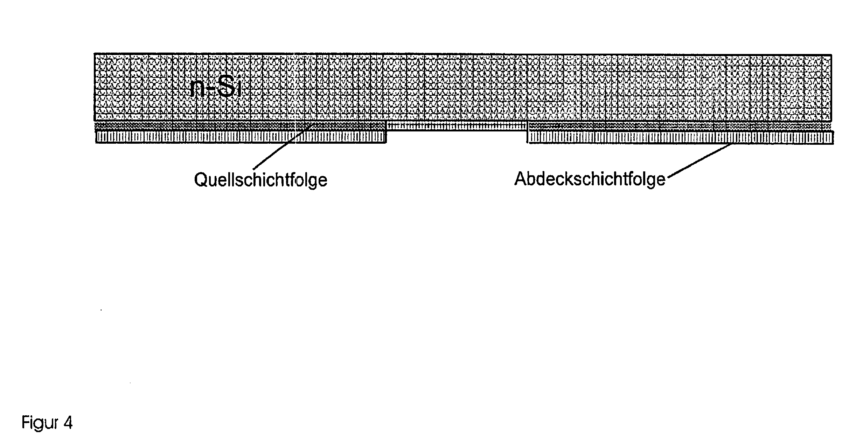

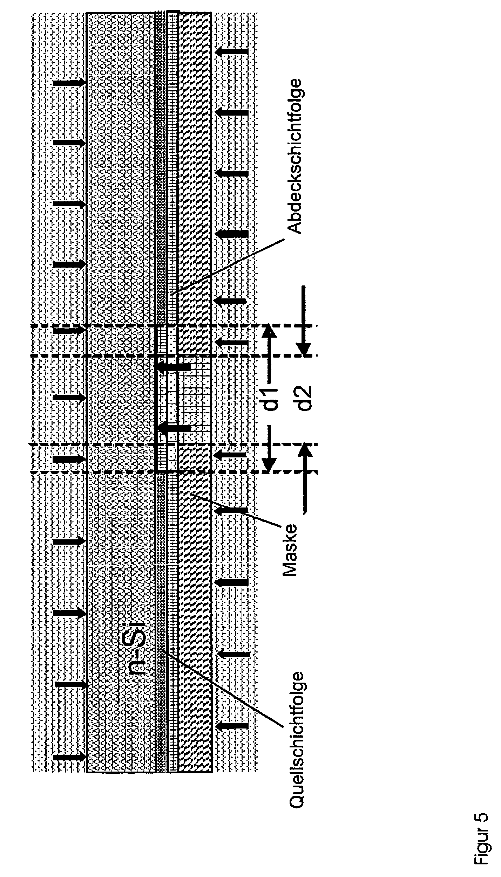

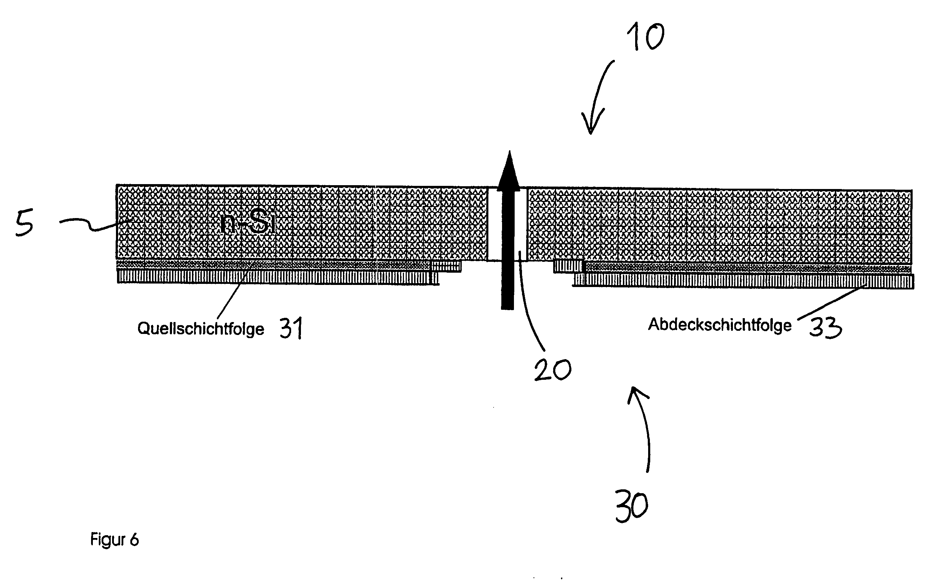

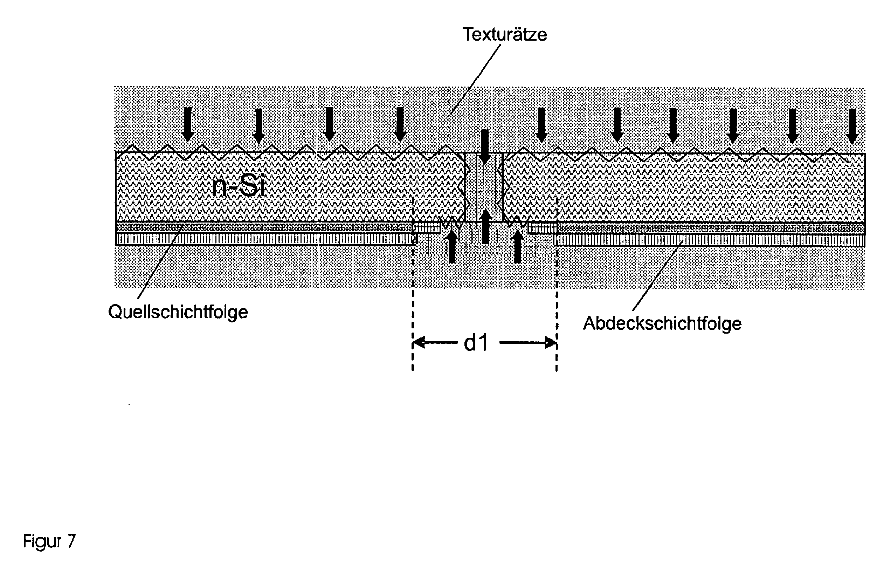

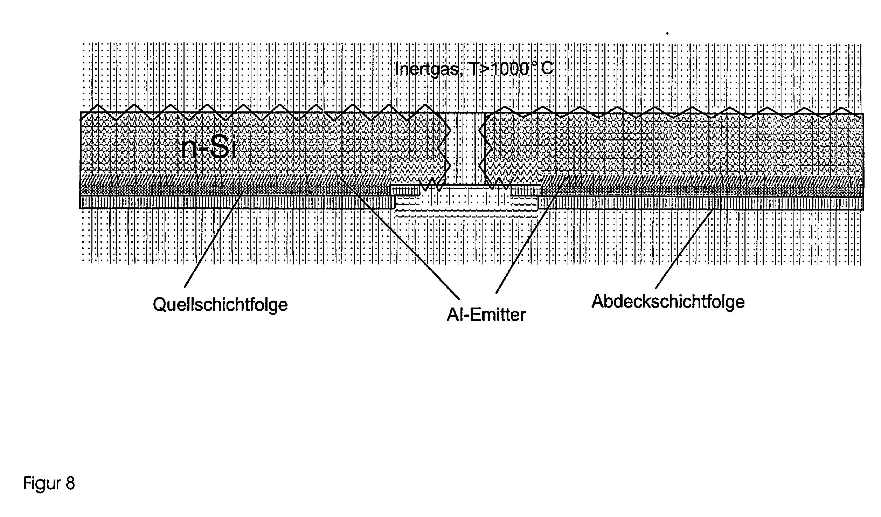

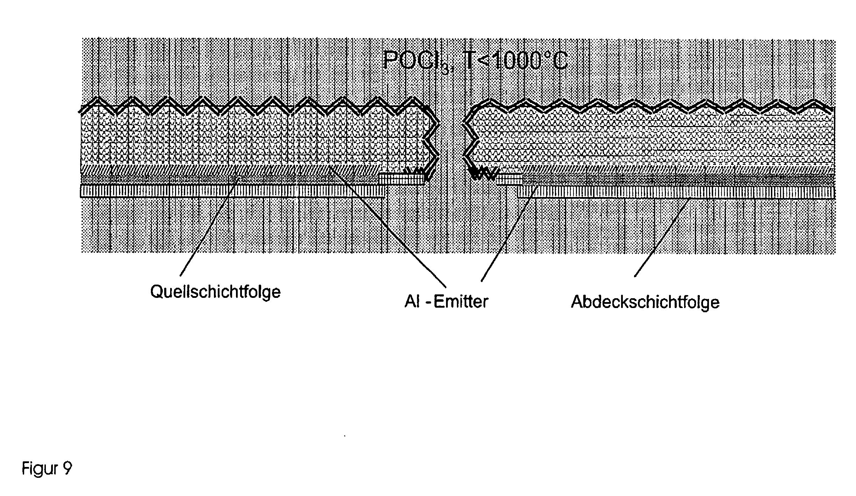

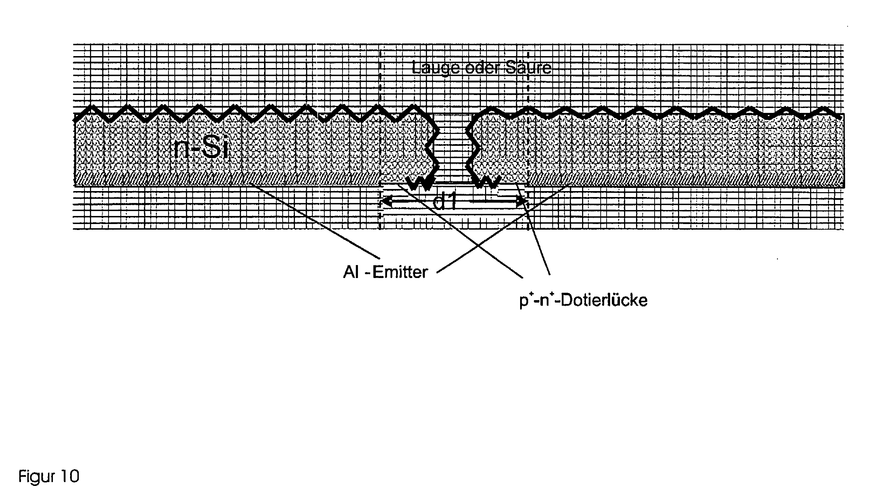

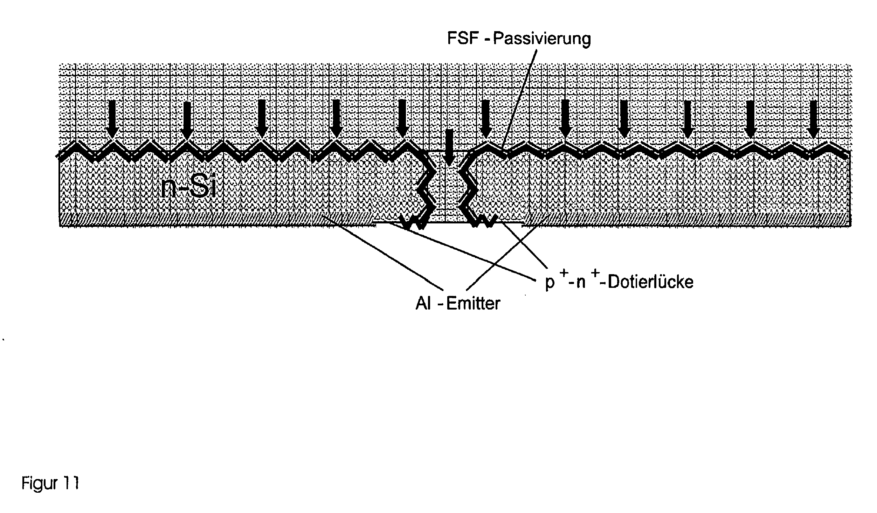

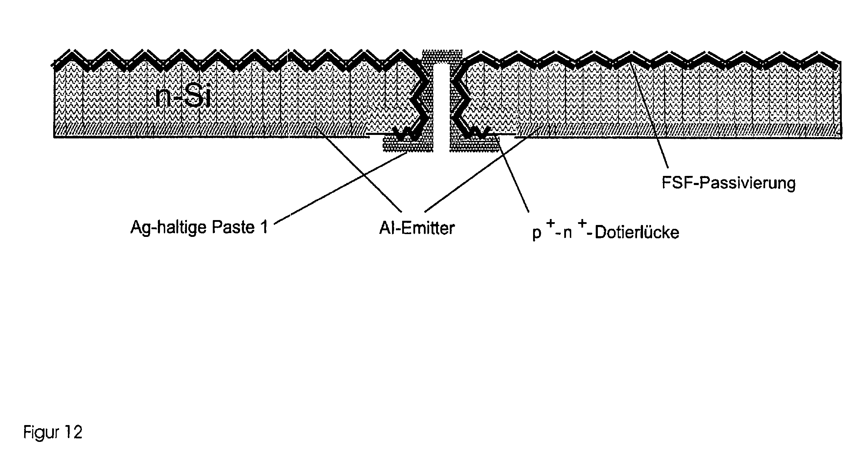

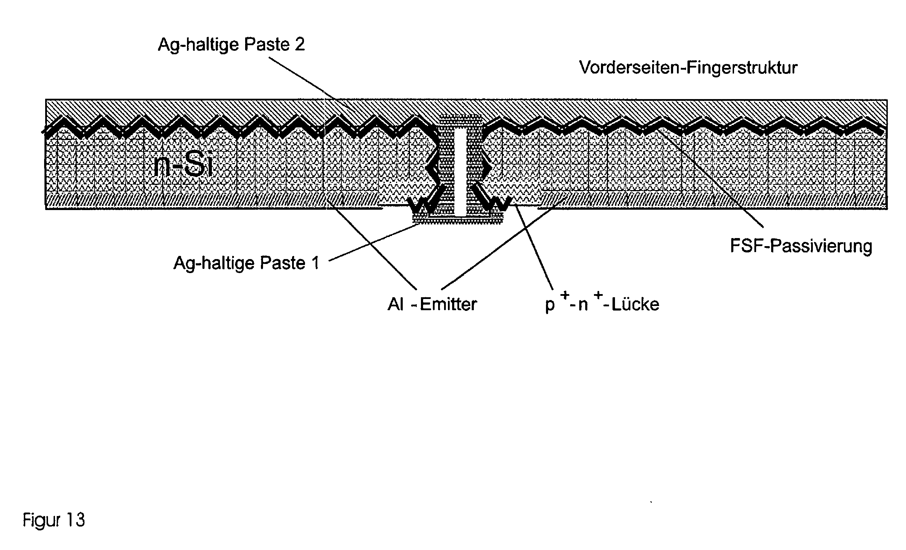

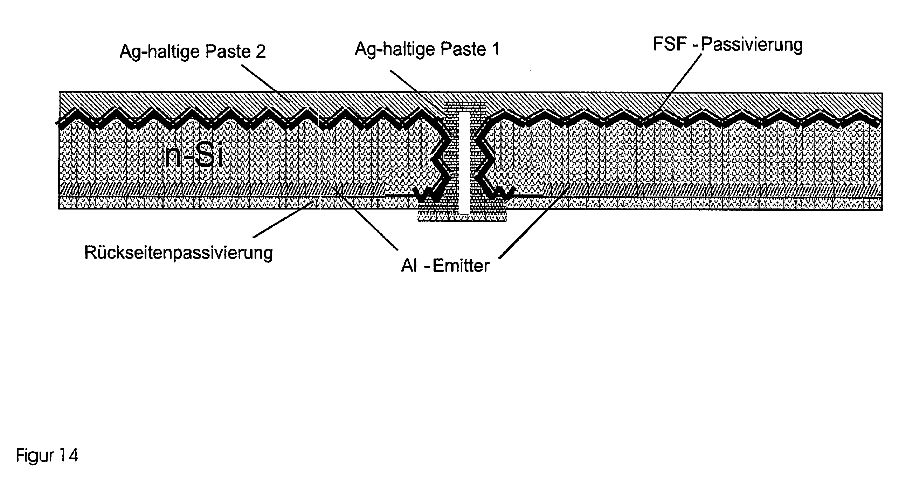

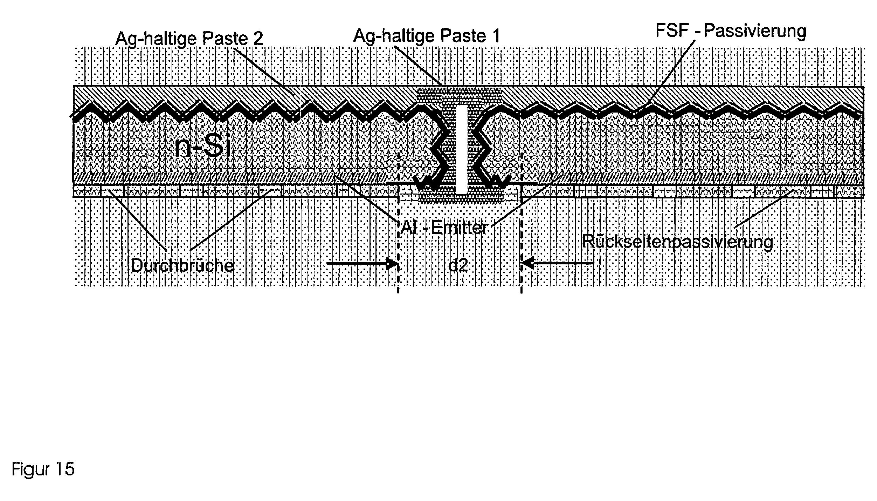

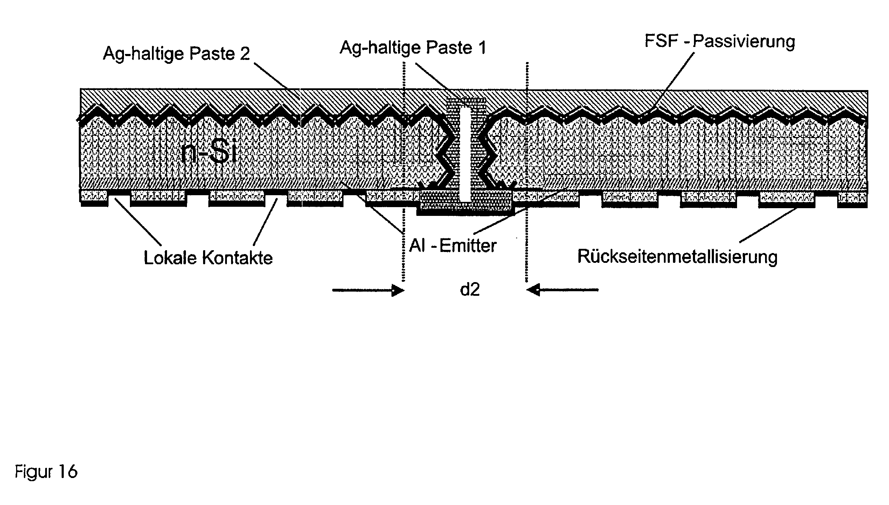

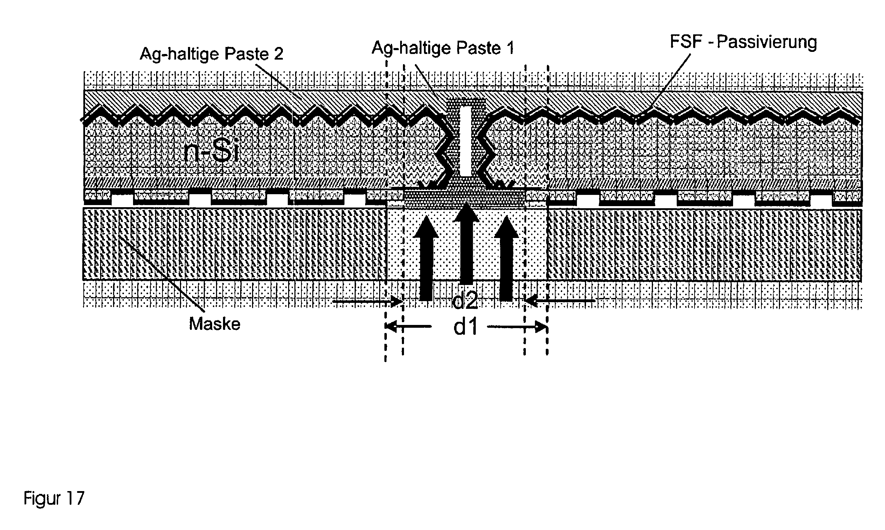

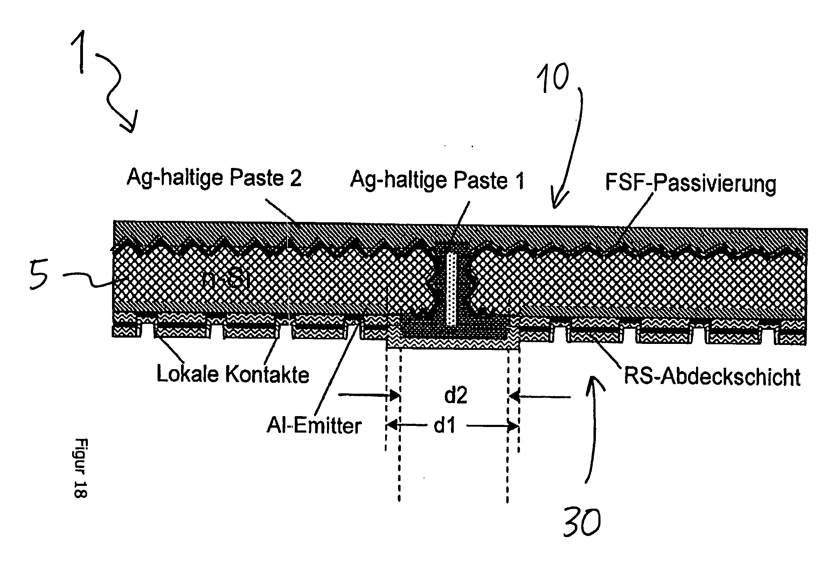

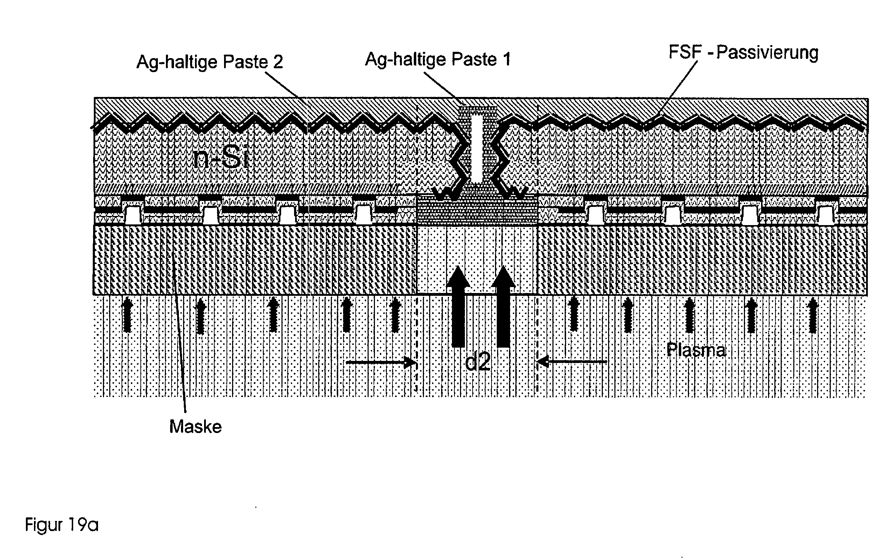

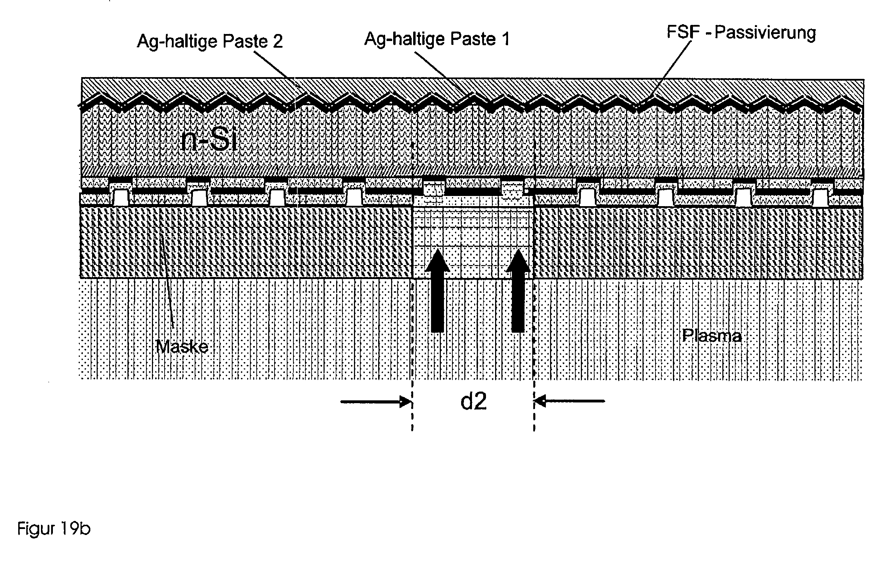

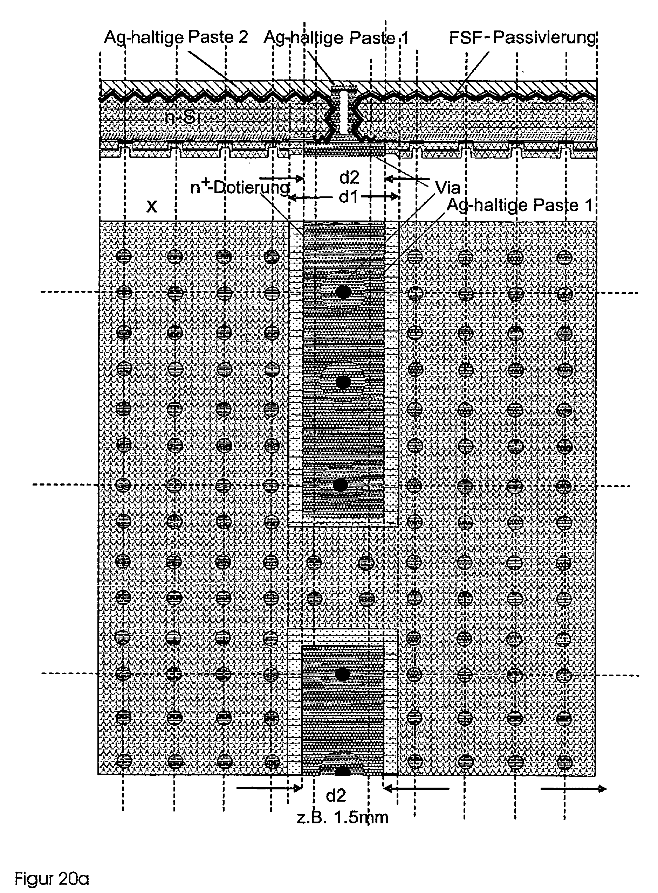

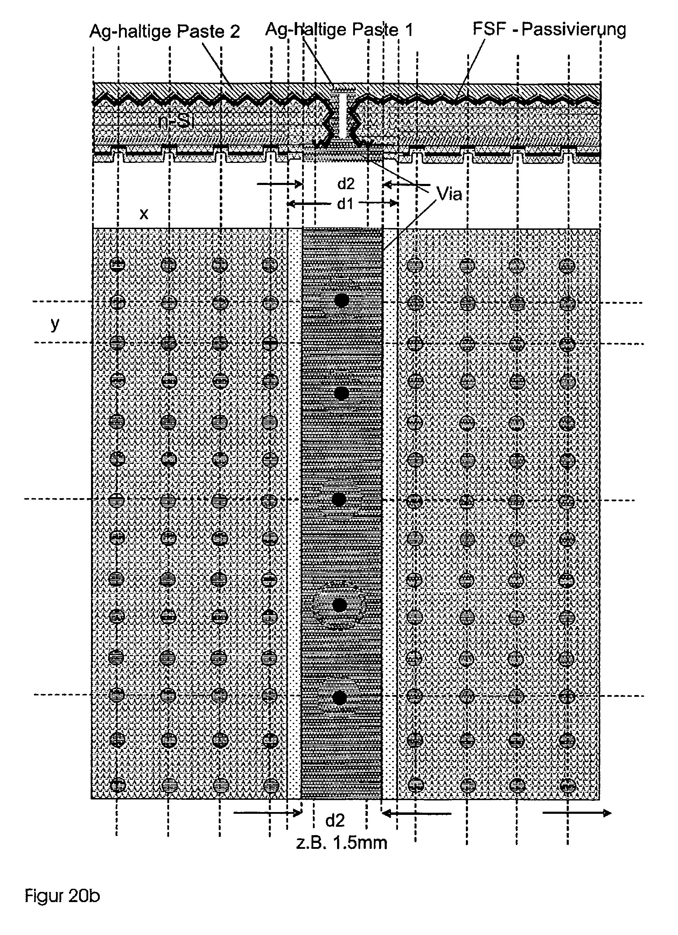

Ausgehend von einem grob gereinigten n-Silizium-Wafer 5, führen die folgenden (beispielhaften) Prozessschritte zu einer bevorzugten Ausführungsform des beschriebenen Zellkonzepts.
1.) Sägeschadenätzung und (optional) RCA-Reinigung der Waferoberflächen (Fig. 1);
2.) Beschichtung der Rückseite 30 mit einer Aluminium-haltigen Quellschicht oder Quellschichtfolge 31 (Fig. 2);
3.) Entfernung der Quellschicht/Quellschichtfolge 31 um die späteren Basis-Busbarbereiche herum, vorzugsweise durch maskiertes Ätzen; dabei ist der freigeätzte Bereich (Fig. 3, Weite d1) breiter als der spätere Basis-Busbar, der über metallisierte Vias 20 mit den Vorderseiten-Metallfingern verbunden werden wird;
4.) Abscheidung einer dielektrischen gegenüber KOH ätzresistenten Abdeckschichtfolge 33 auf der rückseitigen Aluminium-haltigen Quellschicht/Quellschichtfolge 31 (Fig. 4);
5.) Öffnung der dielektrischen Isolierschicht im Bereich der späteren Basis-Busbars vorzugsweise durch maskiertes Ätzen oder durch Ätzpastendruck, wobei diese Öffnungen der Weite d2<d1 die Struktur der späteren n⁺-Dotierung und der darauf zu druckenden Basiskontaktflächen definieren (Fig. 5);
6.) Herstellung der Vias 20 in der Mitte der freigelegten Bereiche der Weite d2 durch Laserbeschuss (Fig. 6);
7.) Texturätzung der Vorderseite 10, der Lochinnenwände und der durch Schritt 5 freigelegten Basis-Busbar-Bereiche der Rückseite durch alkalische Ätzlösung und Abätzen der obersten, KOH-festen Schicht der Abdeckschichtfolge (Fig. 7);
8.) Hochtemperaturdiffusion des Al-Emitters unter der dielektrischen Abdeckschicht, vorzugsweise bei T>1000°C in Inertgasatmosphäre (Fig. 8);
9.) Bei T<1000°C Phosphordiffusion zur Herstellung der n⁺-Dotierung der Vorderseite, der Lochinnenwände und der durch Schritt 5 freigelegten Basis-Busbar-Bereiche der Rückseite (Fig. 9);
10.) Rückätzen der Phosphorsilikatglasschicht (PSG), der rückseitigen Abdeckschicht und der Quellschichtreste oder Quellschichtfolgenreste zur Freilegung des rückseitigen Emitters und des vorderseitigen und bereichsweise rückseitigen FSF in geeigneten nasschemischen Bädern oder in geeignetem Plasma (Fig. 10); dadurch, dass die im Emitter frei geätzten Bereiche breiter sind als die FSF-Bereiche, gibt es einen lateralen Abstand zwischen Emitter- und FSF-Dotierbereichen (n⁺-p⁺-Lücke in Fig. 10), der eine Laserisolation überflüssig macht;
11.) Abscheidung der vorderseitigen Passivier-/Antireflexschicht, vorzugsweise durch PECVD von Siliziumnitrid, entweder direkt auf der Halbleiteroberfläche oder auf einem dünnen Oxid, das vorher durch Oxidieren oder Beschichten abgeschieden worden ist; ebenso möglich ist aber auch jede andere Doppelschicht, bestehend aus einer geeigneten Passivierschicht, z.B. amorphes Silizium (a-Si:H) oder Siliziumkarbid (SiCx), und einer geeigneten Antireflexschicht (Fig. 11);
12.) Drucken der rückseitigen Basiskontaktflächen mit einer geeigneten ersten silberhaltigen Paste mit anschließendem Einsaugen in die lasergeborten Löcher (Vias) und Trocknen der Paste (Fig. 12).
13.) Drucken und Trocknen der vorderseitigen Fingerstruktur mit einer zweiten silberhaltigen Paste, die im Bereich der Vias die erste silberhaltige Paste in den Löchern berührt; gemeinsames Sintern der beiden Pasten mit Durchfeuern durch die vorderseitige Antireflex-Passivierschicht(folge) (Fig. 13).
14.) Optional: Vollflächiges Abscheiden einer rückseitigen Passivierschicht, z.B. amorphes Silizium (a-Si:H) oder Aluminiumoxid oder Aluminiumfluorid, deren Passivierwirkung speziell auf den p⁺-Emitter abgestimmt ist (Fig. 14)
15.) Optional: Strukturierung der optionales rückseitigen Passivierschicht durch maskiertes Ätzen oder durch Ätzpastendruck; dabei Herstellung von lokalen Öffnungen für die Kontaktbildung auf dem Emitter und Freilegung der Basiskontaktflächen um die Vias herum, die bereits in Schritt 12 mit der ersten Ag-haltigen Paste bedruckt wurden (Fig. 15).
16.) Vollflächige Metallisierung der Rückseite direkt auf dem Halbleiter oder auf der optionalen Emitterpassivierung und in den darin im Schritt 15 geöffneten Fenstern, vorzugsweise durch Bedampfen oder Sputtern von aluminiumhaltigem Material (Fig. 16);
17.) Strukturierung der rückseitigen Metallisierung durch maskiertes Ätzen im chlorhaltigen Plasma oder durch Ätzpastendruck; dabei werden insbesondere Basiskontakte freigelegt (Fig. 17);
18.) Optional: Abdeckung der strukturierten rückseitigen Metallisierung mit einer dielektrischen Schutzschicht (Fig. 18);
19.) Optional: Lokale Öffnung der optionalen rückseitigen Abdeckschicht aus Schritt 18, d.h. insbesondere im Bereich der Basisbusbarkontaktflächen (Fig. 19a) und seitlich in den Bereichen der späteren Emitterlötkontakte (Fig. 19b);
20.) Dabei können die lateralen Formen der Öffnungen in der rückseitigen Metallisierung aus Schritt 18 und der Öffnungen in der optionalen Schutzschicht aus Schritt 19 verschieden aussehen: entweder
   (a) von einander getrennte Streifenstücke, die zwei oder mehr Vias mit einander verbinden (Draufsicht in Fig. 20a), wobei zwischen diesen Streifenstücken noch Emitterbereiche mit lokalen Kontakten liegen, oder
   (b) durchgängige Streifen, die alle Vias in einem Busbar mit einander verbinden (Draufsicht in Fig. 20b);
21.) Drucken, Trocknen einer dritten silberhaltigen (Niedertemperatur-)Paste in Bereichen der Ermitterkontaktflächen in den geöffneten Bereichen aus Schritt 19. Dabei kann der Abstand benachbarter Emitterkontakt-Lötflecken der Länge L beliebig, also auch gleich Null, gewählt werden.

Die Ausführung der Erfindung ist nicht auf dieses Beispiel beschränkt, sondern ebenso in einer Vielzahl von Abwandlungen möglich, die im Rahmen fachgemäßen Handelns liegen.

## Patentansprüche

1. Solarzelle (1) mit
- einem n-dotierten Halbleitersubstrat (5), insbesondere aus Silizium, das eine im Gebrauchszustand als Lichteinfallsseite dienende erste Hauptoberfläche (10) und eine als Rückseite dienende zweite Hauptoberfläche (30) hat,
- einem in der ersten Hauptoberfläche (10) vorgesehenen großflächigen, n⁺-dotierten Basisbereich, das heißt Front Surface Field, und einem in der zweiten Hauptoberfläche (30) vorgesehenen großflächigen p⁺-dotierten Emitterbereich, und
- einer auf der zweiten Hauptoberfläche (30) aufgebrachten Emitterkontaktstruktur und ebenfalls dort aufgebrachten Basis-Kontaktbahnen jeweils mit lötfähigen Kontaktflächen,
**dadurch gekennzeichnet, dass**
die Solarzelle (1) eine auf der ersten Hauptoberfläche (10) aufgebrachten fingerartigen Basis-Kontaktstruktur sowie viele die fingerartige Kontaktstruktur der ersten Hauptoberfläche (10) mit den Kontaktbahnen auf der zweiten Hauptoberfläche (30) verbindenden Durchgangskontaktierungen, Vias (20) aufweist, wodurch neben dem Emitterbereich auch der Basisbereich über die lötfchigen Kontaktflächen auf der zweiten Hauptoberfläche (30) kontaktiert werden kann, wobei die zweite Hauptoberfläche (30) bereichsweise, jedenfalls in Bereichen der Basis-Kontaktbahnen, frei von einer p⁺-Emitterdotierung ist, und die erste Hauptoberfläche (10) und vorbestimmte Bereiche der zweiten Hauptoberfläche (30), mindestens um die Vias herum, einen n⁺n-Übergang und damit ein Front Surface Field aufweisen.

2. Solarzelle (1) nach Anspruch 1, wobei auf der zweiten Hauptoberfläche (30) schmale Bereiche zwischen den n⁺-dotierten Basisbereichen und dem sie umgebenden p⁺-dotierten Emitterbereich eine Dotierlücke darstellen, also nur die Basisdotierung des Ausgangsmaterials aufweisen, so dass keine nachträgliche Isoliermaßnahme zur Trennung der hochdotierten Bereiche notwendig ist.

3. Solarzelle (1) nach Anspruch 1 oder 2, wobei die n⁺-Dotierung der ersten Hauptoberfläche (10) mit Phosphor und die p⁺-Dotierung der zweiten Hauptoberfläche (30) mit Aluminium gebildet ist.

4. Solarzelle (1) nach einem der vorangehenden Ansprüche, wobei die n⁺-Dotierung in der ersten Hauptoberfläche (10) unter Fingern der fingerartigen Kontaktstruktur höher als zwischen den Fingern ist.

5. Solarzelle (1) nach einem der vorangehenden Ansprüche, wobei auf der zweiten Hauptoberfläche (30) eine im Wesentlichen vollflächige Metallschicht, insbesondere aus Dünnfilm-Aluminium, zur lokalen oder großflächigen Kontaktierung des Emitters vorgesehen ist, welche in für die Basis-Kontaktierung vorgesehenen Bereichen Ausnehmungen aufweist.

6. Solarzelle (1) nach einem der vorangehenden Ansprüche, wobei auf der zweiten Hauptoberfläche (30), insbesondere zwischen dieser und der im Wesentlichen vollflächigen Metallschicht, eine im Wesentlichen vollflächige dielektrische Abdeckschicht vorgesehen ist, die an vielen Kontaktpunkten und in allen Bereichen mit n⁺n-Übergang mit Öffnungen versehen ist, wobei die Öffnungen um die Vias (20) herum kleiner sind als die dort vorhandenen n⁺n-Bereiche.

7. Solarzelle (1) nach einem der vorangehenden Ansprüche, wobei die auf der zweiten Hauptoberfläche (30) vorhandenen metallisierten n⁺n Bereiche als wenigstens 2 zusammenhängende Busbar-Streifen jeweils über die gesamte Waferlänge oder als kürzere Abschnitte mit einem Abstand voneinander in der Größenordnung eines oder mehrerer Fingerabstände der Kontaktstruktur auf der ersten Hauptoberfläche (10) ausgebildet sind.

8. Solarzelle (1) nach einem der Ansprüche 6 oder 7, falls Anspruch 7 von Anspruch 6 abhängig ist, wobei Aussparungen in der dielektrischen Abdechs Schicht auf der zweiten Hauptoberfläche (30) in den n⁺n-Übergangsbereichen unterhalb der Basiskontaktflächen im Wesentlichen kongruent zur Form der Aussparungen im, insbesondere durch Al-Dotierung gebildeten, Emitterbereich und in der oberflächlichen Metallschicht, aber kleiner als beide ausgebildet sind.

9. Solarzelle (1) nach einem der vorangehenden Ansprüche, wobei die fingerartige Kontaktstruktur auf der ersten Hauptoberfläche aus einer silberhaltigen Siebdruckpaste oder Aerosoldrucktinte und durch Feuern eine dort vorgesehene Antireflexbeschichtung durchdringend gebildet ist.

10. Verfahren zur Herstellung einer Solarzelle (1) nach einem der vorangehenden Ansprüche, **dadurch gekennzeichnet, dass** die n⁺-Dotierung in der ersten Hauptoberfläche (10) und in den vorbestimmten Bereichen der zweiten Hauptoberfläche (30) aus der Gasphase, speziell unter Einsatz von POCl₃, ausgeführt wird, wobei optional unter den Fingern der Kontaktstruktur auf der ersten Hauptoberfläche (10) mit einem Verfahren für die Herstellung eines selektiven Emitters eine höhere Dotierung eingestellt werden kann als zwischen den Fingern, wodurch ein selektives Front Surface Field ausgebildet wird.

11. Verfahren nach Anspruch 10, wobei die p⁺-Dotierung des oder jedes Emitterbereiches auf der zweiten Hauptoberfläche (30) durch die Eindiffusion von Aluminium aus einer Al-haltigen Quellschicht oder Quellschichtfolge (31) ausgeführt wird, welche vollflächig auf die zweite Hauptoberfläche (30) aufgebracht und in den vorbestimmten Bereichen, in denen n⁺-Übergänge oder keine Höherdotierung vorliegen soll, vor einer Eindiffusion des Al in die zweite Hauptoberfläche (30) wieder entfernt wurde.

12. Verfahren nach Anspruch 11, wobei die Al-haltige Quellschicht oder Quellschichtfolge (31) und die optional vorgesehene dielektrische Abdeckschicht (33) auf der zweiten Hauptoberfläche (30) durch ein Vakuum- bzw. Gasphasen-Abscheidungsverfahren, insbesondere Aufdampfen oder Sputtern, aufgebracht wird.

13. Verfahren nach Anspruch 11 oder 12, wobei die Al-haltige Quellschicht oder Quellschichtfolge (31) und die optional vorgesehene dielektrische Abdeckschicht (33) auf der zweiten Hauptoberfläche (30) durch lokale selektive Ätzung, insbesondere mit Ätzpaste oder durch maskiertes plasmagestütztes reaktives Ionenätzen, strukturiert werden.

14. Verfahren nach einem der Ansprüche 11 bis 13, wobei nach der Eindiffusion des Phosphors in die erste Hauptoberfläche (10), die Wandungen der Vias (20) und die vorbestimmten Bereiche der zweiten Hauptoberfläche (30) sowie nach Eindiffusion des Aluminiums in die zweite Hauptoberfläche die bei der Phosphordotierung gebildete Phosphorsilikatglasschicht in den Bereichen des Front Surface Fields sowie die Al-haltige Quellschicht (31) und die optional vorgesehene dielektrische Abdeckschicht (33) vollständig abgeätzt und später die zweite Hauptoberfläche (30) durch einen Abscheidungsvorgang vollflächig mit einer Metallschicht zur Kontaktierung des oder jedes Emitterbereiches bedeckt wird, welche anschließend in Bereichen, die positionsmäßig vorbestimmt sind durch die für n⁺n-Übergänge vorgesehenen Bereiche, aber größer sind als diese, durch ein Ätzverfahren und Einsatz einer Maskierung lokal wieder entfernt wird.

15. Verfahren nach Anspruch 14, wobei vor dem Schritt der Abscheidung der Metallschicht auf der zweiten Hauptoberfläche (30) dort vollflächig eine dielektrische Passivierschicht aufgebracht wird, die an vielen Kontaktpunkten und in den für n⁺n-Übergänge vorgesehenen Bereichen lokal wieder geöffnet wird.

16. Verfahren nach einem der Ansprüche 10 bis 15, wobei die zweite Hauptoberfläche (30) mit einer dielektrischen Schutzschicht vollflächig bedeckt wird, die anschließend nur in den für Lötkontaktflächen vorgesehenen Bereichen auf den p⁺- und n⁺-Gebieten lokal wieder geöffnet wird.

17. Verfahren nach einem der Ansprüche 14 bis 16, wobei die als Ermitterkontaktflächen vorgesehenen p⁺-Bereiche auf der zweiten Hauptoberfläche (30) mit einer silberhaltigen Siebdruckpaste bedruckt werden, die bei Temperaturen unterhalb von 560°C gesintert wird.

## Claims

1. Solar cell (1) comprising
- an n-doped semiconductor substrate (5), in particular composed of silicon, which has a first main surface (10), which serves as light incidents side in the use state, and a second main surface (30), which serves as rear side,
- a large-area n⁺-doped base region, that is to say front surface field, provided in the first main surface (10), and a large-area p⁺-doped emitter region provided in the second main surface (30), and
- an emitter contact structure applied on the second main surface (30) and base contact tracks likewise applied there, in each case with solderable contact areas,
**characterized in that**
the solar cell (1) has a finger-like base contact structure applied on the first main surface (10) and also many plated-through holes, vias (20), connecting the finger-like contact structure of the first main surface (10) to the contact tracks on the second main surface (30), whereby alongside the emitter region contact can also be made with the base region by means of the solderable contact areas on the second main surface (30) wherein the second main surface (30) is free of a p⁺-emitter doping in regions, in any event in regions of the base contact tracks, and the first main surface (10) and predetermined regions of the second main surface (30), at least around the vias, have an n⁺n-junction and thus a front surface field.

2. Solar cell (1) according to Claim 1, wherein on the second main surface (30) narrow regions between the n⁺-doped base regions and the p⁺-doped emitter region surrounding them constitute a doping gap, that is to say have only the base doping of the starting material, such that no subsequent isolating measure is necessary for separating the highly doped regions.

3. Solar cell, according to Claim 1 or 2, wherein the n⁺-doping of the first main surface (10) is formed with phosphorus and the p⁺-doping of the second main surface (30) is formed with aluminium.

4. Solar cell (1) according to any of the preceding claims, wherein the n⁺-doping in the first main surface (10) is higher below fingers of the finger-like contact structure than between the fingers.

5. Solar cell (1) according to any of the preceding claims, wherein on the second main surface (30) a substantially whole-area metal layer, in particular composed of thin-film aluminium, is provided for making local or large-area contact with the emitter, said metal layer having cutouts in regions provided for contact to be made with the base.

6. Solar cell (1) according to any of the preceding claims, wherein on the second main surface (30), in particular between the latter and the substantially whole-area metal layer, a substantially whole-area dielectric covering layer is provided, which is provided with openings at many contact points and in all regions with an n⁺n-junction, wherein the openings around the vias (20) are smaller than the n⁺n-regions present there.

7. Solar cell (1) according to any of the preceding claims, wherein the metallized n⁺n regions present on the second main surface (30) are embodied as at least two continuous busbar strips in each case over the entire wafer length or as shorter sections having a spacing from one another of the order of magnitude of one or a plurality of finger spacings of the contact structure on the first main surface (10).

8. Solar cell (1) according to either of Claims 6 and 7, if Claim 7 is dependent on Claim 6, wherein cutouts in the dielectric covering layer on the second main surface (30) in the n⁺n-junction regions below the base contact areas are embodied substantially congruently with respect to the form of the cutouts in the emitter region, formed in particular by Al doping, and in the superficial metal layer, but are embodied in a manner smaller than both.

9. Solar cell (1) according to any of the preceding claims, wherein the finger-like contact structure on the first main surface is formed from a silver-containing screen printing paste or aerosol printing ink and by firing in a manner penetrating through an antireflection coating provided there.

10. Method for producing a solar cell (1) according to any of the preceding claims, **characterized in that** the n⁺-doping in the first main surface (10) and in the predetermined regions of the second main surface (30) is implemented from the gas phase, specifically using POCl₃, wherein optionally below the fingers of the contact structure on the first main surface (10) by means of a method for the production of a selective emitter a higher doping can be set than between the fingers, as a result of which a selective front surface field is formed.

11. Method according to Claim 10, wherein the p⁺-doping of the or each emitter region on the second main surface (30) is implemented by the indiffusion of aluminium from an Al-containing source layer or source layer sequence (31) which was applied to the second main surface (30) over the whole area and, in the predetermined regions in which n⁺-junctions or no higher doping are/is intended to be present, was removed again before an indiffusion of the Al into the second main surface (30).

12. Method according to Claim 11, wherein the Al-containing source layer or source layer sequence (31) and the optionally provided dielectric covering layer (33) on the second main surface (30) are applied by means of a vacuum or gas phase deposition method, in particular vapour deposition or sputtering.

13. Method according to Claim 11 or 12, wherein the Al-containing source layer or source layer sequence (31) and the optionally provided dielectric covering layer (33) on the second main surface (30) are structured by means of local selective etching, in particular using etching paste or by means of masked plasma-enhanced reactive ion etching.

14. Method according to any of Claims 11 to 13, wherein after the indiffusion of the phosphorus into the first main surface (10), the walls of the vias (20) and the predetermined regions of the second main surface (30) and after indiffusion of the aluminium into the second main surface the phosphosilicate glass layer formed during the phosphorus doping in the regions of the front surface field and the Al-containing source layer (31) and the optionally provided dielectric covering layer (33) are completely etched away and later the second main surface (30) is covered by means of a deposition process over the whole area with a metal layer for making contact with the or each emitter region, which metal layer subsequently, in regions which are positionally predetermined by the regions provided for n⁺n-junctions, but are larger than them, is locally removed again by means of an etching method and use of a masking.

15. Method according to Claim 14, wherein before the step of depositing the metal layer on the second main surface (30), a dielectric passivation layer is applied there over the whole area, which passivation layer is locally opened again at many contact points and in the regions provided for n⁺n-junctions.

16. Method according to any of Claims 10 to 15, wherein the second main surface (30) is covered over the whole area with a dielectric protective layer, which subsequently is locally opened again only in the regions provided for soldering contact areas on the p⁺-and n⁺- regions.

17. Method according to any of Claims 14 to 16, wherein the p⁺-regions provided as emitter contact areas on the second main surface (30) are printed with a silver-containing screen printing paste, which is sintered at temperatures below 560°C.

## Revendications

1. Cellule solaire (1) présentant :
un substrat semi-conducteur (5) à dopage n, en particulier en silicium, qui possède une première surface principale (10) qui, en position d'utilisation, sert de côté d'incidence de la lumière, une deuxième surface principale (30) qui, en position d'utilisation, sert de côté arrière,
une partie de base appelée "front surface field" à dopage n⁺, prévue sur une grande partie de la première surface principale (10),
une partie d'émetteur à dopage p⁺ prévue sur une grande partie de la deuxième surface principale (30) et
une structure de contact d'émetteur appliquée sur la deuxième surface principale (30) et des pistes de contact de base également appliquées sur cette surface et présentant des surfaces de contact aptes à être brasées,
**caractérisée en ce que**
la cellule solaire (1) présente sur la première surface principale (10) une structure de contact de base en forme de doigts ainsi que de nombreuses perforations de contact, à savoir des passages (20) qui relient la structure de contact en forme de doigts de la première surface principale (10) à des pistes de contact prévues sur la deuxième surface de contact (30), grâce à quoi en plus de la partie d'émetteur, la partie de base peut également être mise en contact par l'intermédiaire des surfaces brasées de contact prévues sur la deuxième surface principale (30), certaines parties de la deuxième surface principale (30), en tout cas au niveau des pistes de contact de base, étant exemptes de dopage d'émetteur p⁺ et la première surface principale (10) et des parties prédéterminées de la deuxième surface principale (30) présentant au moins autour des passages une transition n⁺n et donc un "front surface field".

2. Cellule solaire (1) selon la revendication 1, dans laquelle d'étroites zones situées entre les parties de base à dopage n⁺ et la partie d'émetteur à dopage p⁺ qui les entourent constituent sur la deuxième surface principale (30) des lacunes de dopage et présentent donc uniquement le dopage de base du matériau de départ, de sorte qu'il ne faut prendre aucune disposition ultérieure d'isolation pour isoler les parties fortement dopées.

3. Cellule solaire (1) selon les revendications 1 ou 2, dans laquelle le dopage n⁺ de la première surface principale (10) est formé de phosphore et le dopage p⁺ de la deuxième surface principale (30) est formé d'aluminium.

4. Cellule solaire (1) selon l'une des revendications précédentes, dans laquelle le dopage n⁺ est plus haut dans la première surface principale (10) en dessous des doigts de la structure de contact en forme de doigts qu'entre les doigts.

5. Cellule solaire (1) selon l'une des revendications précédentes, dans laquelle une couche métallique, en particulier en film mince d'aluminium, est prévue essentiellement sur la totalité de la deuxième surface principale (30) pour assurer le contact local ou de grande surface de l'émetteur et présente des découpes dans des parties prévues pour le contact de base.

6. Cellule solaire (1) selon l'une des revendications précédentes, dans laquelle une couche diélectrique de recouvrement dotée d'ouvertures aux nombreux points de contact et dans toutes les zones à transition n⁺n est prévue essentiellement sur la totalité de la deuxième surface principale (30), en particulier entre cette dernière et la couche métallique qui la recouvre essentiellement complètement, les ouvertures étant plus petites autour des passages (20) que les zones n⁺n prévues en ces emplacements.

7. Cellule solaire (1) selon l'une des revendications précédentes, dans laquelle les zones n⁺n métallisées prévues sur la deuxième surface principale (30) sont configurées sous la forme d'au moins deux rubans continus de barre de bus, chaque fois au-dessus de la totalité de la longueur de la galette, ou comme sections plus courtes dont l'écart mutuel est de l'ordre de grandeur du ou des écarts entre les doigts de la structure de contact prévue sur la première surface principale (10).

8. Cellule solaire (1) selon l'une des revendications 6 ou 7, dans la mesure où la revendication 7 est subordonnée à la revendication 6, dans laquelle des découpes sont formées dans la couche diélectrique de recouvrement prévue sur la deuxième surface principale (30) dans les zones de transition n⁺n, en dessous des surfaces de contact de base, sous une forme essentiellement congruente avec celle des découpes ménagées dans la partie d'émetteur formée en particulier d'un dopage Al et dans la couche métallique de grande surface, mais plus petite que ces dernières.

9. Cellule solaire (1) selon l'une des revendications précédentes, dans laquelle la structure de contact en forme de doigts prévue sur la première surface principale est formée d'une pâte de sérigraphie contenant de l'argent ou d'une encre d'impression en aérosol et est amenée par cuisson à traverser un revêtement antiréfléchissant prévu en ces emplacements.

10. Procédé de fabrication d'une cellule solaire (1) selon l'une des revendications précédentes, **caractérisé en ce que** le dopage n⁺ est réalisé dans la première surface principale (10) et dans les parties prédéterminées de la deuxième surface principale (30) à partir d'une phase gazeuse, en particulier en recourant à POCl₃, un dopage plus élevé pouvant être établi facultativement en dessous des doigts de la structure de contact prévue sur la première surface principale (10) par un procédé de fabrication d'un émetteur sélectif qu'entre les doigts, ce qui forme sélectivement un "front surface field".

11. Procédé selon la revendication 10, dans lequel le dopage p⁺ de la partie d'émetteur ou de chaque partie d'émetteur prévue sur la deuxième surface principale (30) est réalisé par diffusion d'aluminium à partir d'une couche de gonflement contenant de l'Al ou d'une succession (31) de couches de gonflement qui sont appliquées sur la totalité de la deuxième surface principale (30) et qui, dans certaines parties prédéterminées dans lesquelles des transitions n⁺ où un dopage plus important ne doit pas être présent, ont été enlevées avant la diffusion de l'Al dans la deuxième surface principale (30).

12. Procédé selon la revendication 11, dans lequel la couche de gonflement ou la succession (31) de couches de gonflement contenant de l'Al et la couche diélectrique de recouvrement (33) prévue facultativement sont appliquées sur la deuxième surface principale (30) par un procédé de dépôt sous vide ou en phase gazeuse, en particulier par vaporisation ou pulvérisation.

13. Procédé selon les revendications 11 ou 12, dans lequel la couche ou la succession (31) de couches de gonflement contenant de l'Al et la couche diélectrique de recouvrement (33) prévue facultativement sont structurées sur la deuxième surface principale (30) par gravure locale sélective, en particulier à l'aide d'une pâte de gravure, ou par gravure aux ions réactifs soutenue par plasma à travers un masque.

14. Procédé selon l'une des revendications 11 à 13, dans lequel après diffusion du phosphore dans la première surface principale (10), les parois des passages (20) et les parties prédéterminées de la deuxième surface principale (30) sont enlevées complètement par gravure et après diffusion de l'aluminium dans la deuxième surface principale, la couche de verre au phosphosilicate formée lors du dopage au phosphore dans les zones occupées par le "front surface field", ainsi que la couche de gonflement (31) contenant de l'Al et la couche diélectrique de recouvrement (33) prévue facultativement sont entièrement enlevées par gravure, la deuxième surface principale (30) étant ensuite recouverte complètement par une opération de dépôt d'une couche métallique qui assure le contact avec la ou les zones d'émetteur, la couche métallique étant de nouveau enlevée localement par une opération de gravure et recours à un masque dans les parties prédéterminées par les parties prévues pour les transitions n⁺n, mais étant plus grandes que ces dernières.

15. Procédé selon la revendication 14, dans lequel avant l'étape de dépôt de la couche métallique sur la deuxième surface principale (30), une couche diélectrique de passivation y est appliquée sur toute la surface et est de nouveau ouverte localement aux nombreux points de contact et dans les zones prévues pour les transitions n⁺n.

16. Procédé selon l'une des revendications 10 à 15, dans lequel la deuxième surface principale (30) est recouverte totalement par une couche diélectrique de protection qui est ensuite ouverte de nouveau localement uniquement dans les zones prévues pour les surfaces de contact brasées sur les domaines p⁺ et n⁺.

17. Procédé selon l'une des revendications 14 à 16, dans lequel les zones p⁺ prévues comme surfaces de contact d'émetteur sur la deuxième surface principale (30) sont imprimées à l'aide d'une pâte de sérigraphie contenant de l'argent qui est frittée à une température inférieure à 560°C.
